# EUROPEAN PATENT APPLICATION

(11) **EP 1 976 003 A1**
(43) Date of publication of application: **01.10.2008**
(21) Application number: 07023355.6
(22) Date of filing: 03.12.2007
(51) Int. Cl.: H01L 23/14

(54) **Base substrate for chip scale packaging**

(30) Priority: 28.03.2007 CN 200720005404 U
(71) Applicant: Biar, Jeff, Hsinchu City 300 (TW); Huang, Chih-Kung, Hsinchu City 300 (TW)
(72) Inventor: Biar, Jeff, Hsinchu City 300 (TW); Huang, Chih-Kung, Hsinchu City 300 (TW)
(74) Representative: Straus, Alexander

(57) **Abstract**

A base substrate (10) includes a carrier member (20) and an active member (30). The carrier member (20) is made of electrical conductive metal and has a first through opening (26) with a first diameter. The active member (30) is laminated by a base layer (32) made of electrical conductive metal and an intermediate layer (34) made of electrical insulating or dielectric materials. The active member (30) further has a second through opening (40) with a second diameter being larger than the first diameter of the first through opening (26) of the carrier member (20). The active member (30) is coupled with the carrier member (20) in such a way that a free side (38) of the intermediate layer (34) thereof is attached to an upper surface (22) of the carrier member (20) and the second through opening (40) thereof is aligned with the first through opening (26) of the carrier member (20) to define a shoulder (42) around the first through opening (26).

## Description

### BACKGROUND OF THE INVENTION

### 1. Field of the Invention

The present invention is generally related to chip assembly and packaging, and more particularly, to a base substrate for chip scale packaging.

### 2. Description of the Related Art

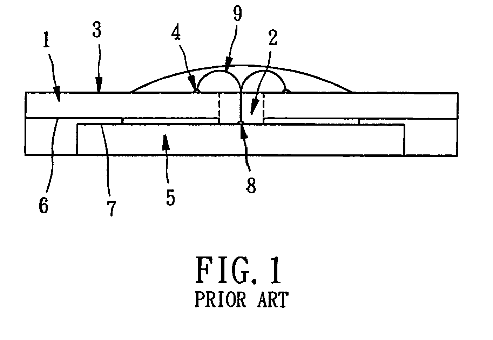

The conventional chip scale packaging, as shown in FIG. 1, generally has a base substrate 1 made of hard materials, such as glass fibers mixed with epoxy resin. Base substrate 1 is constructed to have a center through opening 2 and an upper circuit side 3 with a plurality of bond pads 4. In packaging, a chip 5 is attached to a bottom side 6 of base substrate 1 with an active side 7 thereof. Active side 7 of chip 5 has a plurality of bond pads 8 disposed on the centre portion thereof to interconnect to bond pads 4 via connecting bond wires 9 passing though opening 2.

For being made of hard materials, base substrate 1 is easily deformed or destroyed during packaging processing, such as punching or drilling, used to form through opening 2.

To eliminate this defect, US Patent No. 6,717,276 discloses a base substrate constructed by an upper metal layer, a bottom metal layer with a plurality of openings and an organic tape layer attached therebetween and having a plurality of vias at spaced intervals and which are aligned with the openings of the second metal layer. These vias of the organic tape layer function as receiving channels for receiving a conductive material, such as solder paste. Further, the invention includes a plurality of solder balls aligned with the openings of the second metal layer such that the solder balls are adapted to attach to the solder paste to form a series of electrical interconnects.

From the disclosed contents of the patent, it is known that the vias of the organic tape layer and the openings of the bottom metal layer are formed independently, such as etching or any other suitable method, so that the patented base substrate needs not drilling or punching during packaging processing. And the result is that the defects of the prior art base substrate mentioned above are eliminated.

However, for the patented base substrate, in packaging, needs to fill the vias of the organic tape layer with solder paste and to dispose solder balls over and within the respective openings of the second metal layer. These two processes are generally expensive and time-consuming.

Thus, there is desired an improved base substrate for chip scale packaging which can effectively eliminate these and other defects in prior art base substrates mentioned above.

### SUMMARY OF THE INVENTION

Accordingly, an object of the present invention is to provide a base substrate which can sufficiently meet the demands for miniaturizing and thinning the chip packaging, and which, at the same time, will not be deformed or destroyed during packaging processes , and can be manufactured by a low cost and time-saving way.

Another object of the present invention is to provide an improved base substrate which can effectively improve the electrical performance of a chip attached thereon.

To attain the above objects, a base substrate, according to one aspect of the present invention, comprises a carrier member and an active member. The carrier member is made of electrical conductive metal and has a first through opening with a first diameter. The active member is laminated at least by a base layer made of electrical conductive metal and an intermediate layer made of electrical insulating or dielectric materials. The active member further has a second through opening with a second diameter being larger than the first diameter of the first through opening of the carrier member.

The active member is coupled with the carrier member in such a way that a free side of the intermediate layer thereof is attached to an upper surface of the carrier member and the second through opening thereof is aligned with the first through opening of the carrier member to define a shoulder around the first through opening.

### BRIEF DESCRIPTION OF THE DRAWINGS

These and other objects and features of the present invention will become clearer from the following description of the preferred embodiment given with reference to the attached drawings, wherein:
FIG. 1 is a schematic cross-sectional view of a prior art chip scale packaging;
FIG.2 is a schematic perspective view of a preferred embodiment of a base substrate according to the present invention;
FIG.3 is a cross-sectional view of the base substrate of FIG. 2 taken along line 3-3;
FIG.4 is a schematic perspective view, partly in section, of a chip scale packaging with the base substrate of FIG. 2; and
FIG.5 is a cross-sectional view of the chip scale packaging of FIG. 4 taken along line 5-5.

### DETAILED DESCRIPTION OF THE PRESENT INVENTION

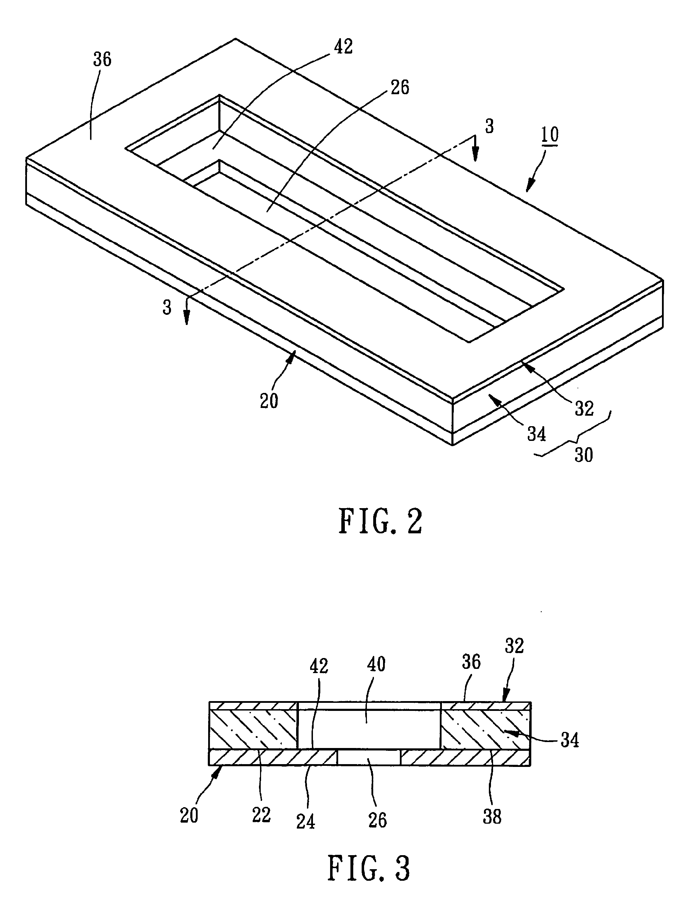

Referring firstly to FIGS. 2 and 3, the drawings illustrate a preferred embodiment of a base substrate 10 according to one aspect of the present invention. The base substrate 10 comprises a carrier member 20 and an active member 30.

The carrier member 20 is made of an electrical conductive metal sheet, such as copper, iron, alloy of copper or any other suitable metal sheets. In this embodiment, the carrier member 20 is made of copper sheet with a predetermined thickness for providing sufficient supporting strength. The carrier member 20 has an upper surface 22, a bottom surface 24 and at least a first elongate through opening 26.

The active member 30 includes a base layer 32 and an intermediate layer 34 attached to the base layer 32. The base layer 32 is also made of an electrical conductive metal sheet, such as copper, iron, alloy of copper or any other suitable metal sheets, but thicker than the carrier member 20. The intermediate layer 34 is made of electrical insulating or dielectric material, such as polymer films, and can be in a single-ply or multi-ply form. In this embodiment, it is in a single-ply form.

The active member 30 has an upper surface 36, and a bottom surface 38 and at least a second elongate through opening 40. The active member 30 is coupled with the carrier member 20 in such a way that the bottom surface 38 (a free side of the intermediate layer 34) thereof is attached to the upper surface 22 of the carrier member 20 and the second through opening 40 thereof is aligned with the first through opening 26 of the carrier member 20 such that the upper surface 22 of the carrier member 20 forms an annular-shaped shoulder 42 around the first through opening 26.

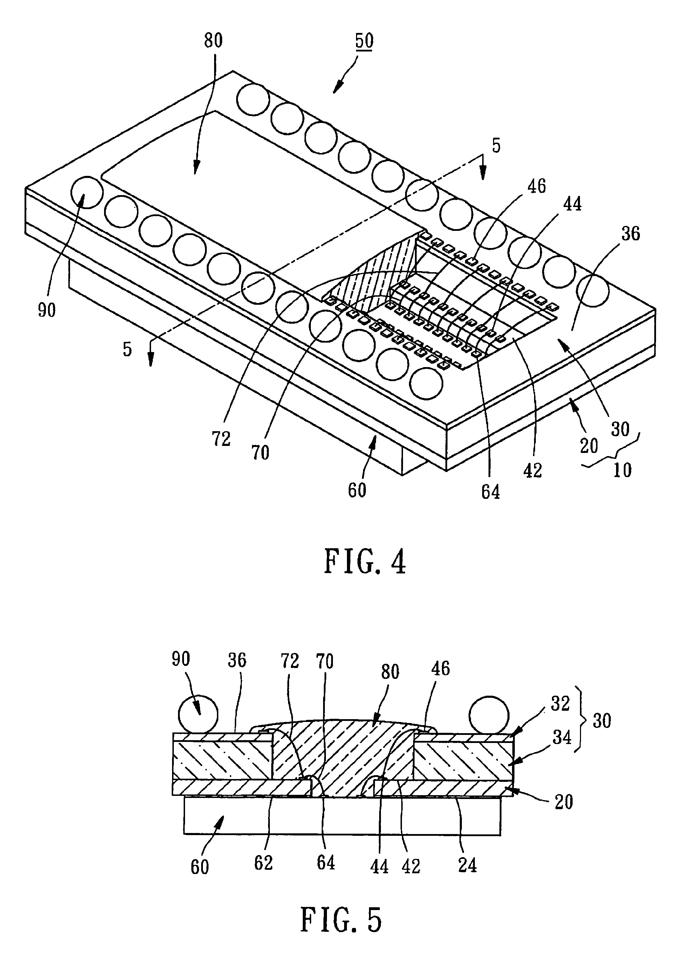

Referring now to FIGS.4 and 5, the drawings illustrate a chip scale packaging 50 with the base substrate 10. The shoulder 42 of the substrate 10 is disposed with a plurality of first bond pads 44. The upper surface 36 of the active member 30 of the substrate 10 is defined an electrical patterns with a plurality of second bond pads 46 disposed around the second through opening 40.

A chip 60 has an active side 62 disposed with a plurality of third bond pads 64 on the center portion thereof. The chip 60 is coupled with the substrate 10 in such a way that the active side 62 thereof is attached to the bottom surface 24 of the carrier member 20 of the substrate 10 and the third bonds 64 of the chip 60 are exposed through the first through opening 26 of the carrier member 20.

The electrical patterns of the active member 30 of the substrate 10 and the chip 60 are electrically interconnected via a first bond wire 70 connecting the third bond pad 64 and the first bond pad 44, and a second bond wire 72 connecting the first bond pad 44 and the second bond pad 46.

A plastic resin 80 is applied over the area covering the first and second through openings 26, 40(as shown in FIG.5). For providing an outer electrical connection, the upper surface 36 of the active member 30 of the substrate 10 can be dsiposed a plurality of solder balls 90 thereon to provide outer electrical connection.

As explained above, for producing without punching, drilling or etching, the base substrate of the present invention not only is capable of eliminating the defects of the prior art but can be manufactured in a low cost and time-saving way. In addition, because the carrier member made of conductive metals is functioned as a grounded layer of the chip packaging, the chip packaging with the base substrate of the present invention certainly has a better electrical performance than the prior art.

## Claims

1. A base substrate (10) for chip scale package, **characterized in that** the base substrate (10) comprises:
a carrier member (20) made of electrical conductive metals and at least having a first through opening (26) with a first diameter;
an active member (30) laminated by a base layer (32) made of electrical conductive metals and an intermediate layer (34) made of electrical insulating or dielectric material, said active member (30) having a second through opening (40) with a second diameter being larger than the first diameter of said first through opening (26) of said base metal member (20);
said active member (30) being coupled with said carrier member (20) in such a way that said intermediate layer (34) thereof is adhered to an upper surface (22) of said carrier member, and said second through opening (40) is aligned with said first through opening (26) of said carrier member (20) to define a shoulder (42) around said first through opening (26).

2. The base substrate according to claim 1, **characterized in that** said carrier member (20) is thicker than said base layer (32) of said active member (30).

3. The base substrate according to claim 1, **characterized in that** said shoulder (42) is annular-shaped around said first through opening (26).

4. The base substrate according to claim 1, **characterized in that** said shoulder is disposed with a plurality of first bond pads (44) thereon.

5. The base substrate according to claim 4, **characterized in that** an upper surface (36) of said base layer (32) of said active member (30) is disposed with a plurality of second bond pads (46) thereon.

6. The base substrate according to claim 5, **characterized in that** said second bond pads (46) are disposed around said second through opening (40).

7. The base substrate according to claim 1, **characterized in that** said intermediate layer (34) of said active member is in a multi-ply form.
